# EUROPEAN PATENT APPLICATION

(11) **EP 1 422 761 A1**
(43) Date of publication of application: **26.05.2004**
(21) Application number: 02758803.7
(22) Date of filing: 08.08.2002
(51) Int. Cl.: H01L 31/042, C23C 16/30

(54) **GLASS PLATE HAVING ELECTROCONDUCTIVE FILM FORMED THEREON**

(30) Priority: 10.08.2001 JP 2001244695
(71) Applicant: Nippon Sheet Glass Company, Limited, Osaka-shi, Osaka 541-8559 (JP)
(72) Inventor: ICHIKI, Kiyotaka, NIPPON SHEET GLASS CO., LTD., Osaka-shi, Osaka 541-8559 (JP); KIYOHARA, Koichiro, NIPPON SHEET GLASS CO., LTD., Osaka-shi, Osaka54 1-8559 (JP); FUJISAWA, Akira, NIPPON SHEET GLASS CO., LTD., Osaka-shi, Osaka 541-8559 (JP)
(74) Representative: Matthews, Derek Peter
(86) International application number: PCT/JP2002/008095
(87) International publication number: WO 2003/017377

(57) **Abstract**

The present invention provides a glass sheet with a conductive film, whose haze ratio is increased by use of irregularities of an undercoating film surface. This glass sheet with a conductive film includes an undercoating film including a layer containing a crystalline oxide as a main component and a conductive film containing a crystalline oxide as a main component, which are formed on a glass sheet in this order, and the haze ratio measured in a state in which the conductive film is removed is at least 0.2%.

## Description

### Technical Field

The present invention relates to a glass sheet with a conductive film and a method for manufacturing the same. This glass sheet with a conductive film has characteristics particularly suitable for a substrate for a photoelectric conversion device.

### Background Art

A glass sheet with a conductive film is used for a substrate for a thin film type solar cell (a thin film type photoelectric conversion device), Low-E glass, or the like. For the glass sheet with a conductive film, an undercoating film may be formed between the glass sheet and the conductive film in order to prevent diffusion of alkali components contained in the glass sheet into the conductive film, since characteristics of the conductive film will deteriorate when the alkali components such as sodium are diffused into the conductive film. A typical material for the undercoating film is silicon oxide, and a typical conductive oxide composing the conductive film is a tin oxide film whose electroconductivity is improved by doping with impurities such as fluorine and antimony.

Surface irregularities provided by crystal grains of an oxide (for example, crystal grains of tin oxide) exposed on the surface of the conductive film will trap light in a photoelectric conversion layer of the thin film type solar cell (thin film type photoelectric conversion device) and contribute to improve the photoelectric conversion efficiency. For obtaining a large effect in trapping light, a haze ratio reflecting the surface irregularities is preferred to be high.

Conventionally, various studies have been carried out regarding surface shapes of conductive films and film forming conditions. However, light-trapping effects caused by the shape of an undercoating film surface (an interface between the undercoating film and the conductive film) have not been noted. Though JP 2000-261013 A discloses improvement of an adhesion strength of a conductive film by use of roughness of an undercoating film, this roughness does not intend to reinforce the light-trapping effect, thereby causing substantially no increase in the haze ratio.

### Disclosure of Invention

The present invention is intended to control a surface shape of an undercoating film so as to increase a haze ratio of an entire substrate with a conductive film.

In order to achieve the aforementioned object, a substrate with a conductive film according to the present invention includes an undercoating film including a layer containing a crystalline oxide as a main component, and a conductive film containing a crystalline oxide as a main component, which are formed on a glass sheet in this order, and a haze ratio measured in a state in which this conductive film is removed is at least 0.2%, or for example, from 0.2% to 3%.

Conventional undercoating films, which are used mainly for preventing diffusion of alkali components or the like, have haze ratios of not more than 0.1%. However, a substrate with a conductive film according to the present invention can obtain a haze ratio of 0.2% or more by means of the undercoating film. By using this undercoating film, a glass sheet with a conductive film is obtained, and the glass sheet has a haze ratio of at least 8%, or for example, from 10% to 50%, preferably at least 20% when measured in a state in which the conductive film is included. A method for forming this undercoating film, which will be described below, uses no or a low concentration of oxygen in the film formation by a chemical vapor deposition (CVD) method. Instead, it uses water (water vapor) as a main oxidizer.

Namely, a method for manufacturing a glass sheet with a conductive film according to the present invention includes forming an undercoating film including a layer containing a crystalline oxide as a main component and a conductive film containing a crystalline oxide as a main component in this order on a glass sheet or a glass ribbon in a process of manufacturing the glass sheet. In this method, the layer is formed by a chemical vapor deposition (CVD) method using a film forming gas containing water vapor. In this film forming gas, an oxygen concentration is not more than 15 mol%.

### Brief Description of Drawings

FIG. 1 is a sectional view of an embodiment of a glass sheet with a conductive film according to the present invention.
FIG. 2 is a view showing a configuration of a device used for manufacturing a glass sheet with a conductive film according to the present invention.

### Preferred Embodiment of the Invention

Preferred embodiments of the present invention are described below by referring to the attached drawings.

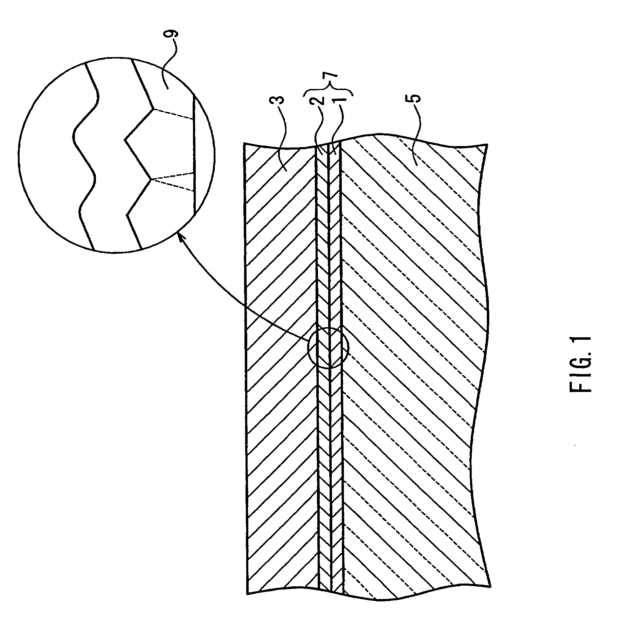

FIG. 1 is a sectional view of an embodiment of a substrate for a photoelectric conversion device according to the present invention. In the substrate, an undercoating film 7 including a first undercoating layer 1 and a second undercoating layer 2, and a conductive film 3 are formed on a flat and smooth surface of a glass sheet 5 in this order. In a surface of the first undercoating layer (an interface with the second undercoating layer), irregularities will appear as crystal grains 9 of an oxide grow. In the present invention, the haze ratio of the undercoating film is improved by growing the crystal grains 9 to be larger in comparison with conventional techniques.

It is preferable that the first undercoating layer 1 is a crystalline film containing, as a main component, at least one component selected from the group consisting of tin oxide, titanium oxide, indium oxide, and zinc oxide. In this specification, the "main component" denotes, as in conventional usage, a component accounting for at least 50 wt% of the whole amount. Therefore, the use of the term "main component" is not intended to exclude the addition of trace components. The first undercoating layer can contain trace components such as fluorine and chlorine. An example of layers containing other components is a tin oxide film containing silicon (SnSiO).

As shown in the drawing, a second undercoating layer 2 can be stacked on the first undercoating layer 1 that contains a crystalline oxide as a main component. This layer is useful for decreasing iridescence and reflectance by using optical interference and also for reliably preventing diffusion of alkali components contained in the glass. For the second undercoating layer, a layer containing a silicon-containing compound as a main component is suitable. Examples of the silicon-containing compound include silicon oxide, silicon oxycarbide (SiOC), and silicon oxide containing tin (SiSnO).

It is preferable that the conductive film 3 contains tin oxide as a main component. The tin oxide can contain trace components such as fluorine and antimony for improving the electroconductivity. Though the amount of the element to be added is not limited specifically, a suitable amount for fluorine is from 0.03 mol% to 1.5 mol%. Other crystalline oxides such as zinc oxide can be used for the main component of the conductive film.

Preferable thickness of the respective films are exemplified below. Further preferable ranges for film thicknesses are indicated in parentheses.
the first undercoating layer: between 10 nm to 120 nm
(between 20 nm to 90 nm)
the second undercoating layer: between 10 nm to 100 nm
(between 20 nm to 90 nm)
the conductive film: between 400 nm to 1200 nm
(between 600 nm to 1000 nm)

Here, it is preferable that a ratio of a thickness (T₂) of the second undercoating layer to a thickness (T₁) of the first undercoating layer, or (T₂/T₁), ranges from 0.1 to 2.0, and depending on the manufacturing condition, it ranges from 0.1 to 1.4, and particularly 0.3 to 1.0. Electric characteristics of the conductive film may deteriorate when this ratio is excessively low, while peaks of the irregular surface may be flattened and the haze ratio may be lowered when the ratio is excessively high.

Though the conductive film is required to have a certain thickness as mentioned above for securing the electroconductivity, increasing the thickness of a crystalline film will be accompanied by a problem of film peeling. The reason is that crystal grains grow to apply pressure to each other to generate an internal stress. Surface roughness of an undercoating film is known to serve to improve an adhesion strength of the conductive film (so called 'anchoring effect'). Due to this anchoring effect, the adhesion strength of the conductive film can be increased to approximately 45 mN (in an example of JP 2000-261013 A, a maximum adhesion strength of 45.1 mN is obtained). Improvement in this level is sufficient in use to obtain a certain effect in case for exclusively improving the adhesion strength. However, as shown in the following Examples, an undercoating film having an adhesion strength of about 45 mN can provide a haze ratio as low as that of a conventional level (about 0.1%). Even when improvement in the haze ratio of the undercoating film is small, it will raise the haze ratio remarkably in a state in which a conductive film is formed, thereby improving considerably the light trapping effect.

Furthermore, as described below, it was confirmed that the adhesion strength of the conductive film was increased to at least 65 mN, and moreover, at least doubled the upper limit (45 mN) of conventional techniques, by using the undercoating film of the present invention. The present invention also provides a glass sheet with a conductive film, and the glass sheet is prepared by forming an undercoating film including a layer containing a crystalline oxide as a main component and a conductive film containing a crystalline oxide as a main component on a glass sheet in this order, and the conductive film has an adhesion strength of at least 65 mN, and further at least 70 mN, and particularly, at least 90 mN. As mentioned above, the present invention can obtain a glass sheet with a conductive film, in which an adhesion strength is improved remarkably in comparison with conventional techniques.

This improvement in the undercoating film was realized as a result of improvement in components of a film forming gas or the film forming temperature. Therefore, a high haze ratio can be obtained even when the film thickness is substantially same as that of a conventional technique (for example, a thickness of the undercoating film is 200 nm or less, preferably 150 nm or less). Though the haze ratio is increased by increasing a thickness of the undercoating film, an excessively thick undercoating film will cause problems, e.g., it will be peeled easily or degrade the visible light transmittance. The degradation of the visible light transmittance will cause undesirable effects such as degradation of the photoelectric conversion effect. However, according to the present invention, it is possible to obtain a glass sheet with a conductive film, whose visible light transmittance measured in a state in which the conductive film is removed is at least 80% while the haze ratio is at least 0.2%.

The substrate according to the present invention is not limited to the embodiment shown in the attached drawing or the above description. For example, the undercoating layer (particularly, the first undercoating layer) is not necessarily a completely continuous film, but this layer can have some defects such as holes in portions. Furthermore, the undercoating film can include additional layers. The conductive film can be made of plural layers, and a protective film can be formed further thereon. The method for manufacturing will not be limited to the suitable example described below, but a glass sheet previously molded can be used for the substrate.

Preferable embodiments of the methods of manufacturing the substrates by industrial mass-production include an on-line CVD method of depositing the above-mentioned respective films sequentially on the top surface of a glass ribbon by utilizing the heat of the glass ribbon in a float glass manufacturing process. In this case, the top surface denotes the surface opposite to the surface (bottom surface) in contact with molten tin in a float bath during the formation by the float glass process.

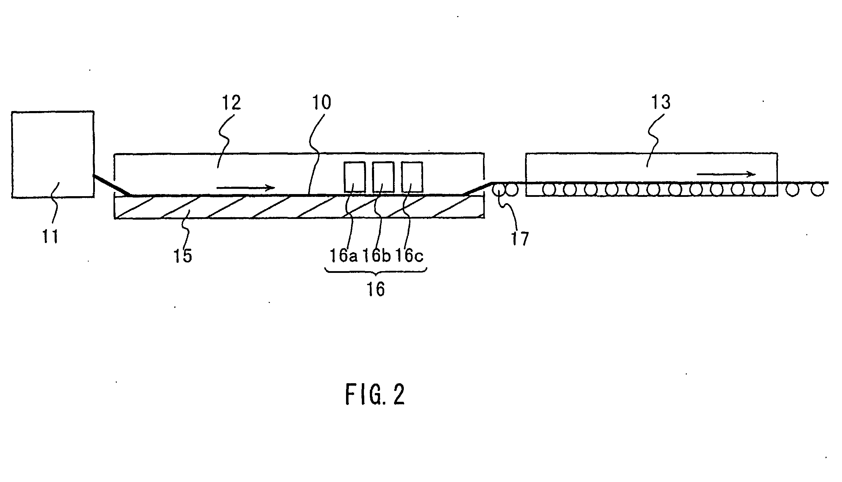

FIG. 2 shows an embodiment of a device for forming a thin film on a glass ribbon surface by the CVD method in a float glass process. In this device, a molten glass material is poured from a furnace 11 into a tin float tank 12, shaped like a belt on a tin bath 15 within this tank, and travels to the downstream side. Within the tank, a predetermined number of coaters 16 (three coaters 16a, 16b and 16c in the embodiment shown in the drawing) are positioned directly above a glass ribbon 10. The number and arrangement of the coaters can be selected suitably depending on the kinds and thickness of the film to be formed. These coaters supply evaporated materials (film forming gas) on the glass ribbon 10 surface in order to stack films. The temperature of the glass ribbon 10 is controlled by a heater and a cooler (not shown in the drawings) installed inside the tin float tank 12 so that the glass ribbon 10 has a predetermined temperature directly before reaching the coaters 16. The glass ribbon 10 with the films thus formed in the tin float tank 12 is lifted by rollers 17, and then annealed in an annealing furnace 13, cut and divided into a predetermined size at a further downstream location.

For further growing the crystal grains of the first undercoating layer, a high substrate temperature, a high water vapor concentration and a low oxygen concentration are effective. It is preferable that the glass temperature for forming this layer is at least 600°C, and particularly at least 650°C, and not higher than 750°C. It is preferable that the concentration of the water vapor is higher than the oxygen concentration. The water vapor can be used for a main oxidizer to oxidize metal, in the form of an oxygen-containing compound with a maximum concentration in the film forming gas. A lower oxygen concentration is preferred. For example, a suitable oxygen concentration is 15 mol% or less, and particularly 10 mol% or less, while it is suitably at least 5 mol% in light of the light transmittance. An embodiment of preferable methods for manufacturing undercoating films according to the present invention includes formation of the above-mentioned layers by the CVD method using a film forming gas containing water vapor as an oxidizer with the highest molar concentration on glass of at least 600°C, when forming on glass (glass sheet or glass ribbon) an undercoating film including a layer containing a crystalline oxide as a main component. A preferable water vapor concentration is in a range of 5 mol% to 40 mol%.

In the case of forming tin oxide films by the CVD method, examples of the tin material to be used include monobutyltin trichloride, tin tetrachloride, dimethyltin dichloride, dibutyltin dichloride, dioctyltin dichloride, tetramethyltin, or the like. When the first undercoating film is formed, an organic tin chloride such as monobutyltin trichloride and dimethyltin dichloride is used suitably. Oxidation materials can include oxygen, water vapor, dry air, or the like. Examples of fluorine materials used when fluorine is added to the conductive film include hydrogen fluoride, trifluoroacetic acid, bromotrifluoromethane, chlorodifluoromethane, or the like.

When a titanium oxide film, an indium oxide or a zinc oxide film is formed, the above-mentioned tin materials may be replaced by, for example, chlorides of the metals (titanium tetrachloride, zinc dichloride, or the like).

In the case where a thin film containing silicon oxide as the main component is formed by the CVD method, examples of the silicon material to be used include monosilane, disilane, trisilane, monochlorosilane, 1,2-dimethylsilane, 1,1,2-trimethyldisilane, 1,1,2,2-tetramethyl disilane, tetramethyl orthosilicate, tetraethyl orthosilicate,or the like. In this case, suitable oxidation materials include oxygen, water vapor, dry air, carbon dioxide, carbon monoxide, nitrogen dioxide, ozone, or the like. When a material with extremely high reactivity such as monosilane or the like is used, an unsaturated hydrocarbon gas such as ethylene, acetylene, toluene, or the like may be added to control the reactivity.

### EXAMPLES

The present invention is described further in detail using examples as follows, but is not limited by the following examples.

In the following examples and comparative examples, thin films are stacked on a glass ribbon surface, using a plurality of coaters by the CVD method as described above. In depositing the films, a mixed gas containing 98 vol.% nitrogen and 2 vol.% hydrogen was supplied to the space inside a tin float tank, so that the pressure inside the tank was maintained to be slightly higher than that outside the tank. A molten soda-lime glass material was introduced into the tin float tank, which then was formed into a glass ribbon with a thickness of 4 mm. The glass ribbon, on the top surface of which predetermined thin films had been stacked inside the tank, was annealed in an annealing furnace and then was washed, dried, and cut at the further downstream location. A specific film forming method is described as follows.

### (Example 1)

The surface temperature of a glass ribbon directly before reaching a coater positioned on the furthest upstream side was set to be 720°C. From this coater, a mixed gas containing dimethyltin dichloride (DMT), water vapor, oxygen and nitrogen was supplied. In this example, concentrations of the water vapor and the oxygen in the mixed gas were determined respectively to be 25 mol% and 7 mol%. Then, from a coater on the downstream side, a mixed gas containing monosilane, ethylene, oxygen and nitrogen was supplied. Subsequently, from a coater on the further downstream side, a mixed gas containing DMT, oxygen, water vapor, nitrogen and hydrogen fluoride was supplied. Thus, a tin oxide film with a thickness of about 40 nm (a first undercoating layer), a silicon oxide film with a thickness of about 20 nm (a second undercoating layer), and a fluorine-containing tin oxide film with a thickness of about 700 nm (a conductive film) were stacked on the top surface of the glass ribbon in this order, thus obtaining a sample.

### (Example 2)

A sample was obtained by the same method as in Example 1 except that the thickness of the tin oxide film was set to be about 44 nm.

### (Example 3)

A sample was obtained by the same method as in Example 1 except that the thickness of the tin oxide film was set to be about 50 nm.

### (Comparative Example 1)

A sample was obtained by applying the same glass temperature and the same mixed gas as in Example 1 except that the mixed gas for forming the tin oxide film contained water vapor and oxygen at concentrations of 0 mol% and 25 mol% respectively. The sample had a tin oxide film with a thickness of about 56 nm, a silicon oxide film with a thickness of about 20 nm, and a fluorine-containing tin oxide film with a thickness of about 700 nm, which were stacked in this order.

### (Comparative Example 2)

The surface temperature of a glass ribbon directly before reaching a coater positioned on the furthest upstream was set to be 750°C. From this coater, a mixed gas containing dimethyltin dichloride (DMT), oxygen, helium and nitrogen was supplied. Then, from coaters positioned on the downstream side, the same mixed gasses as in Example 1 were supplied. In this manner, a tin oxide film with a thickness of about 30 nm, a silicon oxide film with a thickness of about 30 nm, and a fluorine-containing tin oxide film with a thickness of about 700 nm were stacked on the top surface of the glass ribbon in this order, thus obtaining a sample.

Haze ratios of the samples obtained in the respective Examples and Comparative Examples were measured according to the haze value measurement method (Japanese Industrial Standards K7105-1981) with respect to incident light entering from the glass sheet side. The values of the adhesion strength were measured in accordance with "an adhesion test for thin film deposited on glass substrate" (JIS R3255-1997). For measuring the adhesion strength, a scratch tester (CSR-02) manufactured by Rhesca Company Limited equipped with a measuring terminal of diamond having a diameter of 5 µm was used. The load imposed on the tip at time the film surface came to suffer any change presumed to be the initiation of peeling was taken as the adhesion strength, in an observation of optical microphotographs.

Subsequently, only the fluorine-containing tin oxide films (conductive films) were removed from the surfaces of the samples by etching with hydrochloric acid with the use of a zinc powder as a catalyst, so that the surfaces of the silicon oxide films were exposed. Under this condition, the haze ratios were measured in the above-mentioned method. The results are shown in Table 1.

**(Table 1)**

| | Haze ratio (%) | | Adhesion strength (mN) |
|---|---|---|---|
| | Undercoating film alone | Undercoating film with conductive film | |
| Example 1 | 0.2 | 8.2 | 82 |
| Example 2 | 0.3 | 11.3 | 91 |
| Example 3 | 2.0 | 17.6 | 102 |
| Comparative Example 1 | 0.1 | 7.5 | 45 |
| Comparative Example 2 | 0.1 | 6.0 | 38 |

Based on comparison of the results for Examples 1-3, it is obvious that the haze ratio is raised as the first undercoating layer becomes thick when the manufacturing conditions are the same. In addition, it can be confirmed that even if the improvement in the haze ratio of the undercoating film is slight, the haze ratio is improved remarkably in a state in which a conductive film is formed. According to Comparative Example 1, when the adhesion strength of the conductive film was about 45 mN, the haze ratio was as low as about 0.1%.

### (Examples 4-7, Comparative Example 3)

A plurality of samples with tin oxide films (first undercoating layers) and silicon oxide films (second undercoating layers) with thicknesses controlled suitably were manufactured under the same manufacturing condition as in Example 1, and for each of the samples, measurement was carried out for the visible light transmittance, the haze ratio, and the adhesion strength of the conductive film under a condition in which the conductive film was removed. The results are shown in Table 2.

**(Table 2)**

| | Tin oxide film T₁ (nm) | Silicon oxide film T₂(nm) | Visible light transmittance (%) | Haze ratio (%) | Adhesion strength (mN) |
|---|---|---|---|---|---|
| Example 4 | 90 | 45 | 83.6 | 2.0 | 200 |
| Example 5 | 60 | 30 | 85.9 | 0.8 | 130 |
| Example 6 | 50 | 50 | 87.2 | 0.6 | 102 |
| Example 7 | 40 | 30 | 87.1 | 0.3 | 75 |
| Comparative Example 3 | 30 | 45 | 88.0 | 0.1 | 45 |

The respective Examples shown in Table 2 obtained glass sheets with conductive films having high haze ratios of at least 0.2%, or at least 0.6% in some cases and particularly at least 0.8%, and also an adhesion strength improved as well, and high visible light transmittance of at least 80%, particularly at least 83%, and even at least 85% in some cases. These glass sheets realizes high haze ratios even though the thicknesses of the undercoating films (total thickness) are restricted to 150 nm or less, furthermore 135 nm or less, and even 100 nm or less in some cases. On the contrary, the haze ratio was not improved sufficiently in Comparative Example 3. This is attributed to the flattened surface of the undercoating film, resulting from the ratio (T₂/T₁) of the undercoating film being a little too high under this manufacturing condition.

As described above, the present invention can provide a glass sheet with a conductive film, having a haze ratio higher than in conventional techniques. In this glass sheet, an adhesion strength of the conductive film is remarkably high, and the reliability is excellent.

## Claims

1. A glass sheet with a conductive film, comprising:
a glass sheet, an undercoating film including a layer containing a crystalline oxide as a main component, and a conductive film containing a crystalline oxide as a main component, the undercoating film and the conductive film being formed on the glass sheet in this order,
wherein a haze ratio measured in a state in which the conductive film is removed is at least 0.2%.

2. The glass sheet with a conductive film according to claim 1, wherein the haze ratio measured in a state in which the conductive film is included is at least 8%.

3. The glass sheet with a conductive film according to claim 1, wherein the conductive film is a tin oxide film doped with impurities.

4. The glass sheet with a conductive film according to claim 1, wherein the crystalline oxide in the undercoating film is at least one component selected from the group consisting of tin oxide, titanium oxide, indium oxide, and zinc oxide.

5. The glass sheet with a conductive film according to claim 1, wherein the undercoating film comprises a layer containing a crystalline oxide as a main component and a layer containing a silicon-containing compound as a main component, and the layers are formed on the glass sheet in this order.

6. The glass sheet with a conductive film according to claim 5, wherein a ratio of a thickness of the layer containing a silicon-containing oxide as a main component to a thickness of the layer containing a crystalline oxide as a main component is from 0.1 to 2.0.

7. The glass sheet with a conductive film according to claim 1, wherein the undercoating film has a thickness of not more than 200 nm.

8. The glass sheet with a conductive film according to claim 1, wherein the conductive film has an adhesion strength of at least 65 mN, when the adhesion strength is measured in accordance with an adhesion strength test for thin film deposited on glass substrate according to Japanese Industrial Standard (JIS) R3255-1997.

9. The glass sheet with a conductive film according to claim 1, wherein visible light transmittance measured in a state in which the conductive film is removed is at least 80%.

10. A method for manufacturing a glass sheet with a conductive film, comprising:
forming an undercoating film comprising a layer containing a crystalline oxide as a main component and a conductive film containing a crystalline oxide as a main component in this order on a glass sheet or a glass ribbon in a process of manufacturing the glass sheet,
wherein the layer is formed by a chemical vapor deposition method using a film forming gas containing water vapor, and an oxygen concentration in the film forming gas is not more than 15 mol%.
